# EUROPEAN PATENT APPLICATION

(11) **EP 0 893 825 A1**
(43) Date of publication of application: **27.01.1999**
(21) Application number: 97830383.2
(22) Date of filing: 23.07.1997
(51) Int. Cl.: H01L 21/768, H01L 21/3105

(54) **Planarization method with a multilayer for integrated semiconductor electronic devices**

(71) Applicant: STMicroelectronics S.r.l., 20041 Agrate Brianza (Milano) (IT)
(72) Inventor: Locati, Vanda, 24126 Bergamo (IT); Wurthwein, Arturo, 24027 Nembro (Bergamo) (IT); Villa, Monica, 20041 Agrate Brianza (Milano) (IT); Clemente, Gino, 20044 Bernareggio (Milano) (IT); Lo Priore, Stefano, 20052 Monza (IT)
(74) Representative: Botti, Mario

(57) **Abstract**

A planarization method for improving the planarity of electronic devices integrated on a semiconductor substrate (1), which devices comprise a plurality of active elements formed with gate regions (2) which stand proud of the substrate (1) surface and define trench regions (3) therebetween. The method provides for the deposition, within said trench regions (3), of a dielectric stack structure comprising a first layer (4) of undoped oxide, a second layer (5) of oxide deposited over said first layer (4), and a third layer (6) of capping oxide. Also provided are two planarizing substeps consisting of a chemio-mechanical clearing substep followed by a dry etch-back substep to expose the top surfaces of said gate regions (2).

## Description

### Field of the Invention

This invention relates to a planarization method using a multilayer stack, intended for semiconductor-integrated electronic devices.

More particularly, the invention relates to a planarization method for improving the planarity of electronic devices integrated on a semiconductor substrate, said devices comprising a plurality of active elements formed with gate regions which stand proud of the substrate surface and define trench regions therebetween, the method providing for the deposition, within said trench regions, of a dielectric stack structure comprising a first layer of undoped oxide and a second layer of oxide deposited over said first layer.

### Background Art

As is well known, the number of transistors that the manufacturer of electronic circuits succeed to integrate on a single chip appears to increase twofold each passing year.

This doubled density generally does not imply twice the cost, and the cost/performance ratio of semiconductor integrated circuits, such as memories or microprocessors, has seen huge improvements over the years.

One may be brought to wonder, therefore, how far could this process of chip crowding and miniaturizing be led.

The process of fabricating a semiconductor chip is still based on a number of sequential operations wherein the semiconductor is subjected to photolithographic steps, exposed to light, treated with solvents and etched, and implanted dopants or deposited dielectric or conductive layers; all this in order to form on its surface a circuit layout corresponding to a desired circuit architecture.

Memory circuits, such as EPROM, EEPROM, FLASH, NVRAM, DRAM and ROM devices, are among the circuits that have benefited most from this miniaturization process. However, there exists a physical limitation on the possibility of carrying on the miniaturization process indefinitely.

In fact, even assuming that transistors or components of a tiny size were to be obtained, we would still be left with the problem of how to provide the same dimensions for the junctions, which would become too long on account of the thermal treatments.

Long known processes have been in use for dimensional values of up to approximately 1.6x1.6 microns. For smaller dimensions than these, submicron fabrication processes exist which involve certain critical processing operations.

One of these critical operations is the planarization step that must be carried out whenever a dielectric or conductive layer is to be deposited onto a not truly planar surface showing discontinuities or depressions.

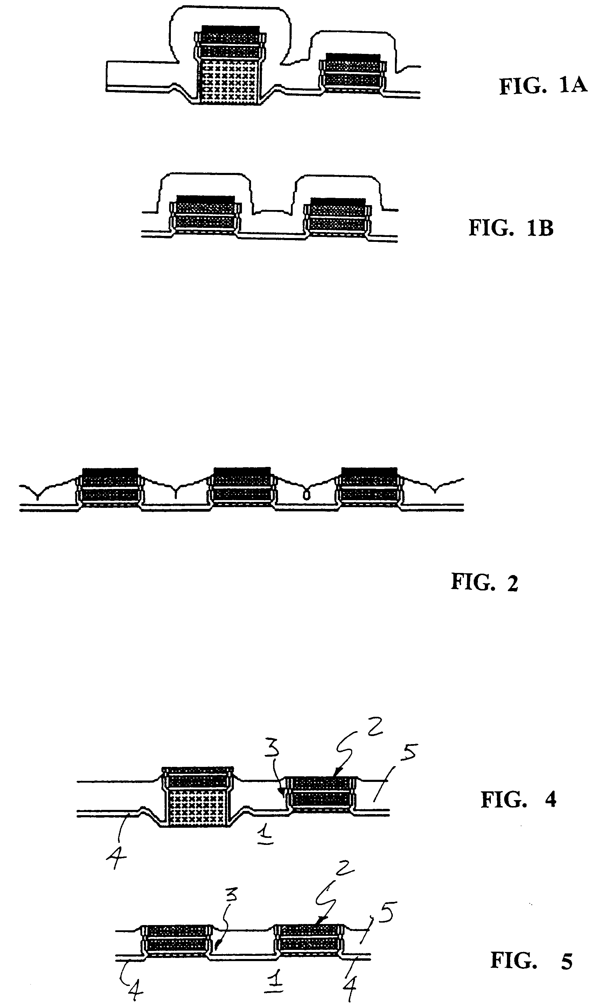

In this respect, Figures 1A and 1B show respective schematic, enlarged-scale vertical cross-section views of a semiconductor portion with different degrees of surface roughness. Clearly represented on the drawing are the different extents of the coverage provided by the last layer deposited over regions with different morphologies.

In fact, the cross-section of a layer being deposited may taper to the point of mechanical failure, due to insufficient step coverage.

A typical instance of this is a plurality of active memory elements -- formed by MOS technology with respective floating gate regions which rise above the substrate surface distinctly and in parallel -- needing reduction to a planar architecture in order to accommodate the deposition of an overlying conductive layer.

To fill this demand, a first prior proposal has been that of depositing a multilayer stack comprised of a first undoped oxide layer and a second oxide layer doped with phosphorus and/or boron.

This stack structure is subjected to a reflow thermal treatment and to planarizing back-etching.

While widely adopted, this prior technique still has some drawbacks, among which is the fact that, with micron size geometries, void may form in the first or the second oxide layer, which voids can, during the back-etching step, turn into holes allowing the etchant solvents to reach the underlying junctions.

Also, the reflow treatment must be applied at a high temperature, which can create problems due to the thermal stress being imposed on the semiconductor device.

In summary, the planarization may prove inadequate at the most critical of spots or regions, for the reasons given above.

Figure 2 illustrates schematically an example of the formation of voids or cracks in the planarizing stack.

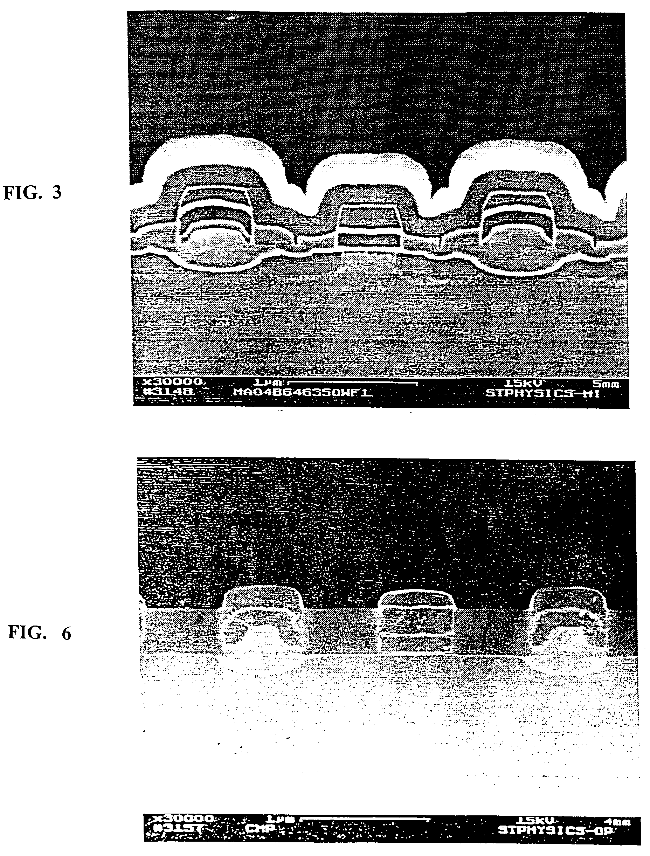

An analysis under the electron microscope of a vertical cross-section through the semiconductor substrate of an electronic memory device, reveals a typical square wave profile as shown in Figure 3. Figure 3 is an electron microphotograph showing a cross-section through a semiconductor substrate formed with contiguous floating gate regions which are isolated from each other by a dielectric oxide layer, and overlaid by a conductive layer.

Dark colored wedges can be recognized on the photo which indicate the presence of cracks in the first oxide layer deposited to fill the interspaces between gate regions. These cracks in the first dielectric layer may spread to the substrate, following the etching steps as mentioned above.

It should also be mentioned that, to meet the requirement for good planarization, the state of the art further proposes a second solution, which consists of using a dual dielectric layers, which are not doped but have different densities or resistances.

For example, it has been suggested of isolating the plurality of floating gates from one another by depositing a first dielectric layer of TEOS (TetraEthylOrthoSilicate). This first dielectric layer is then overlaid with a second dielectric layer of SOG (Spin-On Glass).

This second, SOG depositing step includes a preliminary spinning substep for spreading the material in a highly viscous liquid state, followed by a hardening substep using thermal curing techniques at an illustrative temperature of 400°C.

Thereafter, the planarized surface is subjected to selective back etching in order to thoroughly remove the SOG dielectric layer and confine the TEOS layer to within the interspaces between the plurality of floating gates.

However, this prior solution has a serious drawback in that it is hardly repeatable, unless special equipment is made available, which would raise the cost of the end product significantly. Furthermore, the etching step is difficult to control because of the changing selectivity of the underlying layer uncovered as the etching progresses.

The technical problem underlying this invention is to provide a novel planarization method using a dielectric stack structure, which can overcome the aforementioned limitations and drawbacks besetting the state of the art.

### Summary of the Invention

The solution idea behind this invention is to deposit a multilayer stack comprising a first undoped oxide layer, a second undoped oxide layer under high pressure, and a third or cap oxide layer.

The first oxide layer acts as a barrier, the second layer confers good filling and planarizing characteristics, and the third layer covers the two others.

Furthermore, the planarizing step is carried out in two successive substeps using two different etching techniques: a first Chemical-Mechanical-Polishing technique (CMP), and a second dry etching step.

Based on this solution idea, the technical problem is solved by a method as previously indicated and defined in the characterizing part of Claim 1.

The features and advantages of the deposition method according to this invention will be apparent from the following description of an embodiment thereof, given by way of non-limitative example with reference to the accompanying drawings.

### Brief Description of the Drawings

In the drawings:
Figures 1A and 1B are respective vertical cross-section views, drawn to an enlarged scale, showing schematically portions of a semiconductor which have different degrees of surface roughness;
Figure 2 is a vertical cross-section view, drawn to an enlarged scale, showing schematically a portion of a semiconductor electronic device which has been applied a planarizing step in accordance with the prior art;
Figure 3 is a reproduction of an electron microphotograph of a semiconductor substrate profile corresponding essentially to the example of Figure 2;
Figure 4 is a vertical cross-section view, drawn to an enlarged scale, showing schematically a portion of a semiconductor electronic device which has been applied a planarizing step in accordance with this invention;
Figure 5 is a vertical cross-section view, drawn to an enlarged scale, showing schematically a portion of a semiconductor electronic device whose surface roughness differs from that in Figure 4 and which has been applied a planarizing step in accordance with this invention;
Figure 6 is a reproduction of an electron microphotograph of a plurality of floating gate regions integrated on a semiconductor substrate and isolated from one another by the planarizing method of this invention; and
Figure 7 is a reproduction of a microphotograph similar to Figure 6, but showing devices with surface rough spots rising to different heights above the substrate surface.

### Detailed Description

Referring to the drawing views, a preferred embodiment of the planarizing method according to this invention will be described in detail.

To this aim, a semiconductor portion intended for forming memory cells of a memory array will be considered illustratively, without the Applicant being limited thereto.

This portion comprises a semiconductor substrate 1 having a plurality of active elements integrated thereon which are formed, using MOS technology, with floating gate regions 2 which extend in parallel across the substrate 1 at a spacing from one another.

These floating gate regions 2 define a plurality of trenches in the surface of the semiconductor substrate, with each trench being bounded by two adjacent gate regions.

More particularly, it can be seen in Figure 4 that each floating gate region 2 comprises a basically sandwich structure of different materials, wherein conductive layers alternate with isolation layers. This sandwich structure is configured to allow, under given bias conditions, charge to be retained within a conductive layer sandwiched between two layers of an insulating material.

This charge retention mechanics is typically utilized in EPROM, EEPROM and FLASH EPROM devices to store up a given electric state.

Specifically, each floating gate region or strip 2 comprises: a first thin oxide layer grown onto the semiconductor substrate 1; a first conductive layer of polysilicon, or polyl, deposited onto the thin oxide layer; a third isolating oxide layer, e.g. of ONO (Oxide-Nitride-Oxide); and a second conductive layer of polysilicon, or poly cap, deposited onto said third isolating layer.

When viewed in cross-section to an enlarged scale, each region 2 appears as a "stack" protruding above the surface of the substrate 1.

The method of this invention comprises an initial step of depositing a first layer 4 of a dielectric insulating material to fully cover the semiconductor, and specifically the sidewalls of the trenches 3 and the substrate surface at the trench bottoms.

This first dielectric layer 4 is an undoped silicon oxide acting as a barrier.

Thereafter, a second dielectric layer 5, that is a layer 5 of undoped silicon oxide, is deposited.

This second layer 5 acts as a filler and is deposited under a predetermined pressure in order to obtain well filled and planarized trenches 3.

It is preferred that the second layer 5 has a good filling factor, which detracts from the density characteristics of the oxide.

The trench regions 3 are filled in such a manner that the floating gate regions 2 are also covered.

A third or capping layer 6 is deposited over the second layer 5 which is also undoped silicon oxide.

To set the third layer 6 and make it more like thermal oxides, a thermal setting cycle is applied.

The resultant structure is, therefore, a stack of three distinct layers 4, 5 and 6 of undoped silicon oxide.

Advantageously in this invention, the step of planarizing the stack structure 4, 5, 6 is carried out in two successive separate substeps. For these substeps, moreover, two different technologies are employed.

A first processing substep is a CMP (Chemical Mechanical Polishing) treatment effective to produce a mechanically truly planar surface.

WIth this technique, the third oxide layer 6 is almost thoroughly removed, down to the neighborhood of the tops of the stacks represented by the tallest of the regions 2. A purely chemical etching method cannot be used here because it would fail to planarize the stack properly.

The second processing substep is a dry or plasma etching step carried out using a fluorine-based chemical species, which enables the stack to be etched back such that the tops of the stacks represented by the floating gate regions 2 are exposed.

At the end of this etch-back substep, the top surfaces of the stacks should be left exposed in view of subsequent depositions of conductive layers which are to contact the tops of the floating gate regions 2.

It should be noted in this respect that the completion of the inventive method includes an end point detection method for stopping the second etch-back step upon the top surface of the lowest among the stacks or regions 2 being reached on the semiconductor.

The method of this invention has proved specially effective, in fact, with electronic devices having stacks of different height above the substrate surface.

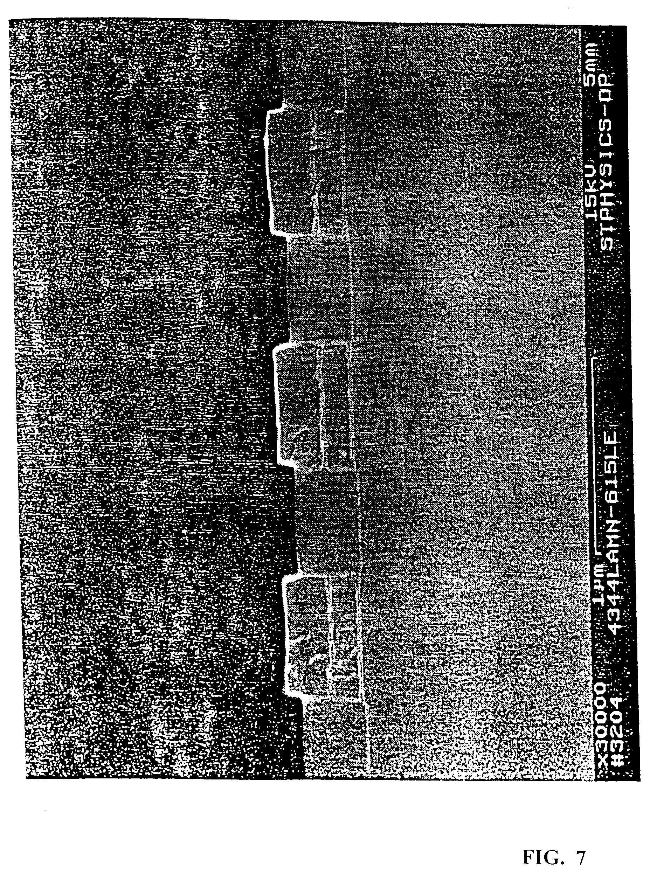

For example, the reproduced photos of Figures 6 and 7 illustrate two examples of semiconductor portions having different height stacks.

The method of this invention does solve the technical problem, and offers a number of advantages, foremost among which is the fact that the process described hereinabove will be compatible with any of the miniaturization techniques to come.

In addition, by using dielectrics which do not require high settting or reflowing temperatures, undesired dopant diffusions are avoided.

The method disclosed ensures an excellent filling of the areas being planarized and a good degree of planarization even in the most critical of the areas.

The process has good repeatability and can be implemented on the production line without burdening the latter with checking procedures in excessive amounts.

In conclusion, the method of this invention allows circuit architectures of the type described above to be planarized, while reconciling the need for low-temperature processing steps with that to provide reliable planarizing dielectric structures free of microvoids or cracks.

All of the above-mentioned advantages of the deposition method according to the principles of this invention can be recognized and confirmed by analysis under the electron microscope, as shown in Figures 6 and 7, of any semiconductor substrates having dielectric stack structures requiring planarization.

## Claims

1. A planarization method for improving the planarity of electronic devices integrated on a semiconductor substrate (1), said devices comprising a plurality of active elements formed with gate regions (2) which stand proud of the substrate (1) surface and define trench regions (3) therebetween, the method providing for the deposition, within said trench regions (3), of a dielectric stack structure comprising a first layer (4) of undoped oxide and a second layer (5) of oxide deposited over said first layer (4), characterized in that it further comprises a step of depositing a third layer (6) of a cap oxide, and two planarizing substeps providing a Chemical-Mechanical-Polishing CMP first step followed by a dry etch-back second step to expose the top surfaces of said gate regions (2).

2. A method according to Claim 1, characterized in that a thermal setting treatment is applied after the deposition of said third layer (6).

3. A method according to Claim 1, characterized in that said third layer (6) is undoped silicon oxide.

4. A method according to Claim 1, characterized in that said dry-etch back substep is a plasma etching step carried out using a fluorine-based chemical species.

5. A method according to Claim 1, characterized in that it provides for end-point detection in order to stop said dry etch-back substep upon the top surface of the lowest of the regions (2) formed on the semiconductor being reached.

6. A method according to Claim 1, characterized in that said second layer (5) is deposited under a predetermined pressure to ensure good filling of the trenches (3).

7. A method according to Claim 1, characterized in that said second layer (5) exhibits a good filling factor.
